# EUROPEAN PATENT SPECIFICATION

(11) **EP 1 259 975 B1**
(45) Date of publication and mention of the grant of the patent: **21.04.2004**
(21) Application number: 01904276.1
(22) Date of filing: 12.02.2001
(51) Int. Cl.: H01J 37/32

(54) **AN ATMOSPHERIC PRESSURE PLASMA SYSTEM**
EINE PLASMAANLAGE MIT ATMOSPHÄRISCHEM DRUCK
SYSTEME A PLASMA A PRESSURE ATMOSPHERIQUE

(30) Priority: 11.02.2000 IE 000123
(43) Date of publication of application: 27.11.2002
(73) Proprietor: Dow Corning Ireland Limited, Midleton, County Cork (IE)
(72) Inventor: Herbert, Anthony, Cork (IE); O'Reilly, Fergal, Cork (IE); Braddell, Jules, Cork (IE); Dobbyn, Peter, Cork (IE)
(74) Representative: Schütte, Gearoid
(86) International application number: PCT/IE2001/000023
(87) International publication number: WO 2001/059809

(56) References cited:
- WO-A-95/08182
- FR-A- 2 774 400
- GB-A- 2 324 196
- GB-A- 2 332 881
- US-A- 5 529 631

## Description

The present invention relates to an atmospheric pressure plasma system and in particular to a method and process for using plasmas at atmospheric and/or ambient pressure in industrial manufacturing, processing and production using precursor process gases other than ambient air.

When matter is continually supplied with energy, its temperature increases and it typically transforms from a solid to a liquid and, then, to a gaseous state. Continuing to supply energy causes the system to undergo yet a further change of state in which neutral atoms or molecules of the gas are broken up by energetic collisions to produce negatively charged electrons, positive or negatively charged ions and other species. This mix of charged particles exhibiting collective behaviour is called "plasma", the fourth state of matter. Due to their electrical charge, plasmas are highly influenced by external electromagnetic fields which makes them readily controllable. Furthermore, their high energy content allows them to achieve processes which are impossible or difficult through the other states of matter, such as by liquid or gas processing.

The term "plasma" covers a huge range of systems whose density and temperature vary by many orders of magnitude. Some plasmas are very hot and all their microscopic species (ions, electrons, etc.) are in approximate thermal equilibrium, the energy input into the system being widely distributed through atomic/molecular level collisions. Other plasmas, however, particularly those at low pressure (e.g. 100 Pa) where collisions are relatively infrequent, have their constituent species at widely different temperatures and are called "non-thermal equilibrium" plasmas. In these non-thermal plasmas the free electrons are very hot with temperatures of many thousands K while the neutral and ionic species remain cool. Because the free electrons have almost negligible mass, the total system heat content is low and the plasma operates close to room temperature thus allowing the processing of temperature sensitive materials, such as plastics or polymers, without imposing a damaging thermal burden onto the sample. However, the hot electrons create, through high energy collisions, a rich source of radicals and excited species with a high chemical potential energy capable of profound chemical and physical reactivity. It is this combination of low temperature operation plus high reactivity which makes non-thermal plasmas technologically important and a very powerful tool for manufacturing. and material processing, capable of achieving processes which, if achievable at all without plasma, would require very high temperatures or noxious and aggressive chemicals.

For industrial applications of plasma technology, a convenient method is to couple electromagnetic power into an enclosure backfilled with process gas (which term "gas" shall hereinafter include gas mixtures and vapours) and containing the work-pieces/samples to be treated. The gas becomes ionised into plasma generating the chemical radicals, UV-radiation and ions which react with the surface of the samples. By correct selection of process gas composition, driving power frequency, power coupling mode, pressure and other control parameters, the plasma process can be tailored to the specific application required by the manufacturer.

Because of the huge chemical and thermal range of plasmas, they are suitable for many technological applications which are being continually extended. Non-thermal equilibrium plasmas are particularly effective for surface activation, surface cleaning / material etching and coating of surfaces.

The surface activation of polymeric materials is a widely used industrial plasma technology pioneered by the automotive industry. Thus, for example, the polyolefines, such as polyethylene and polypropylene, which are favoured for their recylability, have a non-polar surface and consequent poor disposition to coating or gluing. However, treatment by oxygen plasma results in the formation of surface polar groups giving high wettability and consequent excellent coverage and adhesion of metal paint, adhesive or other coating. Thus, for example, plasma surface engineering is essential to the manufacture of vehicle fascias, dashboards, bumpers etc. and to component assembly in the toy, etc. industries. Many other applications are available in the printing, painting, gluing, laminating and general coating of components of all geometries in polymer, plastic, ceramic/inorganic, metal and other materials.

The increasing pervasiveness and strength of environmental legislation world-wide is creating substantial pressure on industry to reduce or eliminate the use of solvents and other wet chemicals in manufacturing, particularly for component/surface cleaning. In particular, CFC-based degreasing operations have been largely replaced by plasma cleaning technology operating with oxygen, air or other non-toxic gases. Combining water based pre-deaning with plasma, even heavily soiled components can be cleaned and surface qualifies obtained typically superior to those resulting from traditional methods. Any organic surface contamination is rapidly scavenged by room temperature plasma and converted to gaseous CO₂ and water which can be safely exhausted.

Plasmas can also carry out etching of a bulk material, i.e. removal of unwanted material. Thus, for example, an oxygen based plasma will etch polymers, a process used in the production of circuit boards, etc. Different materials such as metals, ceramics and inorganics are etched by careful selection of precursor gas and attention to the plasmachemistry. Structures down to nanometre critical dimension are now being produced by plasma etching technology.

A plasma technology that is rapidly emerging into mainstream industry is that of plasma coating/thin film deposition. Typically, a high level of polymerisation is achieved by application of plasma to monomeric gases and vapours. Thus, a dense, tightly knit and three-dimensionally connected film can be formed which is thermally stable, chemically very resistant and mechanically robust. Such films are deposited conformally on even the most intricate of surfaces and at a temperature which ensures a low thermal burden on the substrate. Plasmas are therefore ideal for the coating of delicate and heat sensitive, as well as robust materials. Plasma coatings are free of micropores even with thin layers ( e.g. 0.1 mm). The optical properties, e.g. colour, of the coating can often be customised and plasma coatings adhere well to even non-polar materials, e.g. polyethylene, as well as steel (e.g. anti-corrosion films on metal reflectors), ceramics, semiconductors, textiles, etc.

In all these processes, plasma engineering produces a surface effect customised to the desired application or product without affecting the material bulk in any way. Plasma processing thus offers the manufacturer a versatile and powerful tool allowing choice of a material for its bulk technical and commercial properties while giving the freedom to independently engineer its surface to meet a totally different set of needs. Plasma technology thus confers greatly enhanced product functionality, performance, lifetime and quality and gives the manufacturing company significant added value to its production capability.

These properties provide a strong motivation for industry to adopt plasma-based processing, and this move has been led since the 1960s by the microelectronics community which has developed the low pressure Glow Discharge plasma into an ultra-high technology and high cost engineering tool for semiconductor, metal and dielectric processing. The same low pressure Glow Discharge type plasma has increasingly penetrated other industrial sectors since the 1980s offering, at more moderate cost, processes such as polymer surface activation for increased adhesion / bond strength, high quality degreasing/cleaning and the deposition of high performance coatings. Thus, there has been a substantial take-up of plasma technology.

However, adoption of plasma technology has been limited by a major constraint on most industrial plasma systems, namely their need to operate at low pressure. Partial vacuum operation means a closed perimeter, sealed reactor system providing only off-line, batch processing of discrete work-pieces. Throughput is low/moderate and the need for vacuum adds capital and running costs.

Atmospheric pressure plasmas, however, offer industry open port/perimeter systems providing free ingress into and exit from the plasma region by work-pieces/webs and, hence, on-line, continuous processing of large or small area webs or conveyor-carried discrete work-pieces. Throughput is high, reinforced by the high species flux obtained from high pressure operation. Many industrial sectors, such as textiles, packaging, paper, medical, automotive, aerospace, etc., rely almost entirely upon continuous, on-line processing so that open port/perimeter configuration plasmas at atmospheric pressure offer a new industrial processing capability.

Corona and flame (also a plasma) treatment systems have provided industry with a limited form of atmospheric pressure plasma processing capability for about 30 years. However, despite their high manufacturability, these systems have failed to penetrate the market or be taken up by industry to anything like the same extent as the low pressure, batch-processing-only plasma type. The reason is that corona/flame systems have significant limitations. They operate in ambient air offering a single surface activation process and have a negligible effect on many materials and a weak effect on most. The treatment is often non-uniform and the corona process is incompatible with thick webs or 3D work-pieces while the flame process is incompatible with heat sensitive substrates. It has become clear that atmospheric pressure plasma technology must move much deeper into the atmospheric pressure plasma spectrum to develop advanced systems meeting industry needs. However, to do this, it is essential to move from ambient air plasmas to plasmas formed from other precursor process gases. Such plasmas have properties different to ambient air plasmas and, thus, the potential for new and/or improved industrial processes. However, any move to new types of atmospheric pressure plasmas will only be industrially relevant if they include the ability to operate in the open port/perimeter configuration consistent with on-line, continuous manufacture.

A wide range of potentially useful industrial processes based upon non-ambient-air plasmas at atmospheric pressure have been demonstrated by researchers including surface activation, etching/cleaning and surface coating. Such processes rely upon the use of non-ambient-air precursor gases including Helium, Argon, Nitrogen, Oxygen, Halocarbons, Silanes, organic and inorganic monomers, Halogens, SiCl₄, SiF₄, Hydrocarbons, Hydrogen, etc. Such gases are costly and/or hazardous and/or environmentally harmful and require containment in and confinement to the region in which the plasma is generated and the work-piece processed and close thereto. Furthermore, the composition of the process gas in the plasma region must be tightly controlled for process optimisation and reproducibility, so that the introduction of contaminant gases from the ambient air surrounding the plasma system must be eliminated or minimised. These requirements motivate a precursor process gas containment system as an integral part of any novel industrial atmospheric pressure plasma processing system using non-ambient-air process gas which confines injected process gas to and near to the plasma region and minimises or prevents the incursion into the plasma region of unwanted ambient air or other gas while, at the same time, allows the open port/perimeter configuration essential to on-line, continuous production.

US Patent Specification No. 5529631 (Yoshikawa et al) discloses an atmospheric plasma system similar to that of the present invention, in one embodiment of which the location of the exit and entrance ports to the chamber or sealed enclosure are near the bottom of the enclosure below the plasma region for helium gas which is lighter air.

The present invention is directed towards providing these and other objects.

### Statements of Invention

According to the invention, there is provided an atmospheric pressure plasma (APP) system of the non-thermal equilibrium type comprising: electrodes forming a plasma region mounted in a gas-tight enclosure housing having an open to the atmosphere entry port assembly and exit port assembly, a non-ambient air precursor process gas having a relative density greater or less than ambient air at the same pressure and temperature and means for moving work-pieces between the electrodes from the entrance port assembly to the exit port assembly characterised in that each assembly port comprises an elongate enclosed housing having a work-piece port opening connecting the housing to the outside of the enclosure housing and a vertically spaced-apart work-piece enclosure opening connecting the housing to the enclosure housing and wherein the work-piece enclosure opening is below the work-piece port opening and is sited in the enclosure housing above the plasma region for precursor process gas with a relative density greater than that of the ambient air and below the plasma region and above the work-piece enclosure opening for a gas with a relative density less than that of ambient air.

The advantage of this construction is that most of the precursor process gas does not escape out the plasma region during continuous operation. That obviates the high cost of large quantities of expensive precursor process gas and further, by reducing the extent of the loss of gas, health and safety hazards are greatly reduced since many of the precursor process gas may be toxic, an asphyxiant, an irritant and even harmful explosive. A further advantage is that by keeping the plasma region relatively free of contaminants, a more efficient control of the process may be carried out with increased replicability. The longer the housing and the greater the vertical spacing provided between the work-piece enclosure opening and the work-piece port opening are, the less likelihood there is of contaminant gases entering the housing. Ideally, a gas analyzer is mounted in the entry port assembly and preferably it is located adjacent the work-piece enclosure opening. Further, a gas analyser may be mounted in the exit port assembly and ideally is mounted adjacent the work-piece port opening. In both cases, the gas analyser may be connected to a control means for the introduction of precursor process gas on the quantity of precursor process gas sensed by the analyser falling below a predetermined level.

Ideally, the precursor process gas is maintained at a slight positive pressure above ambient pressure outside the enclosure housing. In this way, by a relatively modest increase in pressure within the enclosure housing, it is possible to keep the enclosure free of contaminant gases.

Ideally, the positive pressure of the precursor process gas is less than 1 % of ambient.

In one embodiment of the invention, control means are provided whereby the positive pressure is maintained by the introduction of precursor process gas when the pressure within the enclosure housing falls below a predetermined minimum level. Alternatively, means are provided for continuously introducing precursor process gas into the enclosure housing. Ideally, means are provided for the collection and removal of gases adjacent the exterior of each port assembly where a work-piece enters or leaves the port assembly.

In one embodiment of the invention, the means for collection and removal of the gases comprise a cowling surrounding the port assemblies and an extraction fan associated therewith. In one embodiment of the invention, the cowling comprises an open gas receiving mouth adjacent the work-piece port opening. The advantage of this is that the gases, whether they be exhaust gases or precursor process gases are withdrawn from the enclosure housing, particularly where the enclosure housing is pressurised. They may be collected for recycling or at least for safe disposal.

In another embodiment, an exhaust gas vent is provided in the enclosure on the side of the enclosure opposite to the port assemblies for the collection of exhaust gases having a relative density to that of the process precursor gases whereby they are trapped in the enclosure housing. In this latter embodiment, an exhaust gas sensor is mounted in the enclosure housing adjacent the exhaust gas vent. Then control means may be connected to the exhaust gas sensor and the exhaust gas vent for the operation of the exhaust gas vent on the level of exhaust gases in the enclosure housing exceeding a predetermined level.

Ideally gas flow dampers are mounted in each port assembly. Such gas flow dampers may be one or other of lip seals; brush seals; curtain seals; and opposed rollers. Other well known gas dampers do not need any further description but anything that will reduce the perturbation of the gas is to be preferred.

In one embodiment of the invention, the electrodes are substantially planar electrodes. In the latter embodiment of the invention, there are a plurality of electrodes arranged back to back and in which the means for moving the work-pieces between the electrodes comprises a conveyor or a web moving back and forth sequentially between the electrodes.

In another embodiment of the invention, when the work-piece is endless yarn, the means provided for moving the work-piece comprises an open frame member for mounting between two electrodes, the frame member carrying a plurality of yarn support pulleys on opposite sides of the frame member and a yarn draw-off mechanism.

It is envisaged that the electrodes may comprise a pair of U-shaped members of dielectric material nesting one inside the other to define the plasma region therebetween carrying an electrode on the outer surface of the outer of the two members and carrying a corresponding electrode on the inner surface of the other member.

### Detailed Description of the Drawings

The invention will be more clearly understood from the following description of some embodiments thereof, given by way of example only, with reference to the accompanying drawings, in which:-
Fig. 1 is a diagrammatic view of an atmospheric pressure plasma system according to the invention,
Figs. 2 to 6 are diagrammatic views of other systems according to the invention,
Fig. 7 is an exploded schematic view of a system according to the invention,
Fig. 8 is a detailed view of a yarn handling rack according to the invention,
Fig. 9 is a perspective view of an electrode arrangement for use with the yarn handling rack of Fig. 8,
Fig. 10 is a side view of the yarn handling rack and electrode assembly of Figs. 8 and 9 assembled together,
Fig. 11 is a front view of the yarn handling rack, and
Fig. 12 is an enlarged perspective view of part of the yarn handling rack.

Before referring to the drawings, it will be appreciated that a precursor process gas or vapour will have a unique density and thus a unique relative density. In this specification, "relative density" is the ratio of the density of a gas to the density of the ambient air at the same temperature and pressure. When discussing "precursor process gas", one is referring to the ratio of the density of that gas to the density of ambient air at the same temperature and pressure. Therefore, if this ratio is less than 1, the gas is lighter than the ambient air and will tend to rise and float above the ambient air while, if the ratio or density is greater than 1, then the gas is heavier than the ambient air and will tend to sink.

Essentially, the principle of the present invention is that by encasing the plasma region in an enclosure housing which is gas tight, except for open port assemblies allowing free ingress to the plasma and exit therefrom by work-pieces then, if the open port assemblies are sited correctly, then it is possible to avoid the escape of the precursor process gas. In the case of the relative density of the precursor process gas being less than 1, then the entry port assembly and the exit port assembly must be sited in the lowest part of the enclosure housing. When this is done, then all the precursor process gas, when injected into the enclosure housing, will rise to fill the enclosure housing from the top down duly expelling all the ambient air out of the enclosure housing or at least away from the plasma region defined by the electrodes. Similarly, in the case of the precursor process gas having a relative density greater than 1, then the precursor process gases will naturally fall within the enclosure housing and thus the enclosure housing will have to have its entry and exit port assemblies in the highest part of the housing enclosure.

Needless to say, in this specification, highest and lowest is used in its normal sense, that is to say, the highest being furthest away from the gravitational pull of the earth, and the lowest being closer.

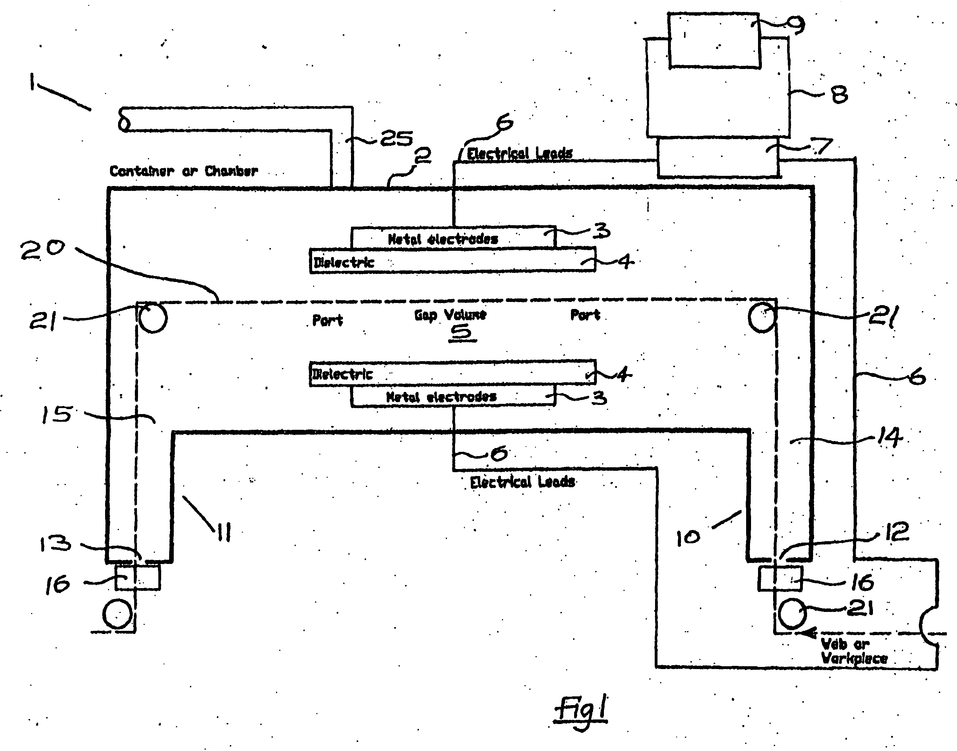

Referring to the drawings and initially to Fig. 1, there is illustrated an atmospheric pressure plasma (APP) system, indicated generally by the reference numeral 1 of the non-thermal equilibrium type comprising an enclosure housing 2 containing a pair of electrodes 3 mounted on a dielectric material 4 forming therebetween a plasma region 5. The dielectric can be any suitable dielectric such as glass. The electrodes 3 are connected in conventional manner by electric leads 6 to a suitable RF (radio frequency) transformer 7 connected by suitable cabling 8 to an RF supply 9. The enclosure housing 2 is gas tight except for an entry port assembly, indicated generally by the reference number 10, and an exit port assembly, indicated generally by the reference numeral 11. The entry port assembly 10 and the exit port assembly 11 each have a work-piece opening 12 and 13 and a work-piece enclosure opening 14 and 15 respectively. The two work-piece endosure openings 14 and 15 are in this embodiment, directly above the work-piece port openings 12 and 13. Adjacent each work-piece opening 12 and 13, there is mounted suitable gas flow dampers 16. The gas flow dampers 16 can be in the form of lip seals, brush seals, opposing rollers or curtain seals, indeed, all types of seal. Means for moving work-pieces through the enclosure housing is provided by a conveyor or web 20 shown by interrupted lines travelling across pulleys 21. The conveyor 20 is not shown in any detail nor indeed, for example, is the drive or retum pulleys of the conveyor 20. However, all of these are conventional. The conveyor 20 simply comprises means for holding work-pieces to deliver the work-pieces through the plasma region 5. Alternatively, if the work-piece is in the form of a web it is simply tensioned over the pulleys 21 and pulled through the plasma region 5. A suitable gas feed pipe 25 for injection of precursor process gas is illustrated and is connected to a source of precursor process gas which is not shown.

In operation, suitable precursor gas lighter than air such as, for example, helium, having a relative density less than that of the ambient air at the temperature and ambient pressure prevailing, i.e. less than 1.0 as defined above, is fed into the enclosure housing 2 through the gas feed pipe 25. The lighter than air gas will occupy initially the top of the enclosure housing 2 and then will gradually fill up the enclosure as more is fed in pushing out the ambient air until there is no ambient air in the enclosure housing 2 or in either the entry port assembly 10 or the exit port assembly 11. The work-pieces are placed on the conveyor 20 and the conveyor 20 is operated to bring work-pieces through the plasma region 5 and with the plasma system operating, then the necessary plasma processing will take place in the plasma region 5.

In operation, as the conveyor 20 progresses through the gas flow damper 16 into the work-piece opening 12, the gas flow damper 16 will minimise the entry of ambient air into the system and thus will ensure that there will be little or no perturbation of the plasma. Further, the gas flow dampers will ensure that little contaminating ambient air be dragged or carried into the enclosure housing 2. Generally, on exiting out the work-piece port opening 13, the gas flow dampers 16 will prevent the dragging out of precursor process gas into the surrounding atmosphere. The embodiment of Fig. 1 is a simple construction of the atmospheric process plasma system according to the invention.

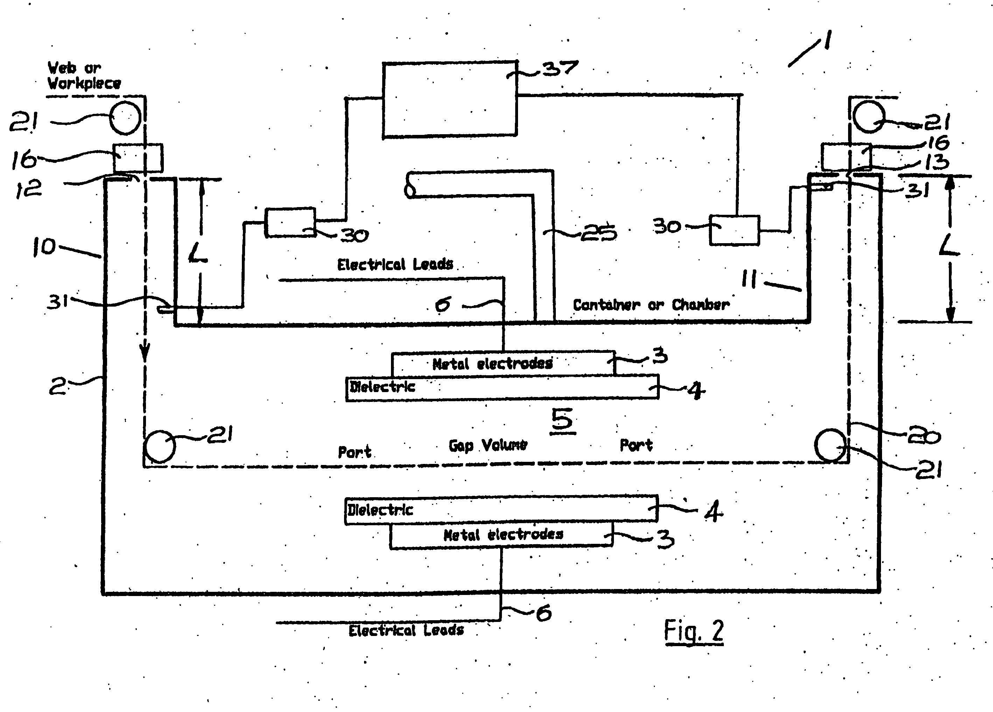

Fig. 2 illustrates an alternative construction of APP system, again identified by the reference numeral 1 and parts similar to those described with reference to the previous drawing, are identified by the same reference numerals. In this embodiment, the APP system 1 is adapted for use with precursor process gases whose relative density is greater than 1, that is to say, their density is greater than that of the ambient air at the same pressure and temperature. In this embodiment, there is provided a pair of gas analysers 30 each having a probe 31, one is sited in the entry port assembly 10 adjacent the work-piece enclosure opening 14 and the other in the exit port assembly 11 adjacent the work-piece port opening 13. Both gas analysers 30 are connected to a controller 37 in turn connected to the precursor gas supply. When the gas analysers 30 indicate that either the entry port assembly 10 is becoming contaminated with ambient air adjacent the work-piece enclosure opening 14 or the exit port assembly 11 is removing too much of the precursor process gas through the work-piece port opening 13, the precursor gas flow can be adjusted accordingly. The greater the length L is, that is to say, the vertical distance between the work-piece port opening and the work-piece enclosure opening the less the amount of contaminants will enter. The port assemblies will form what are in effect gas traps.

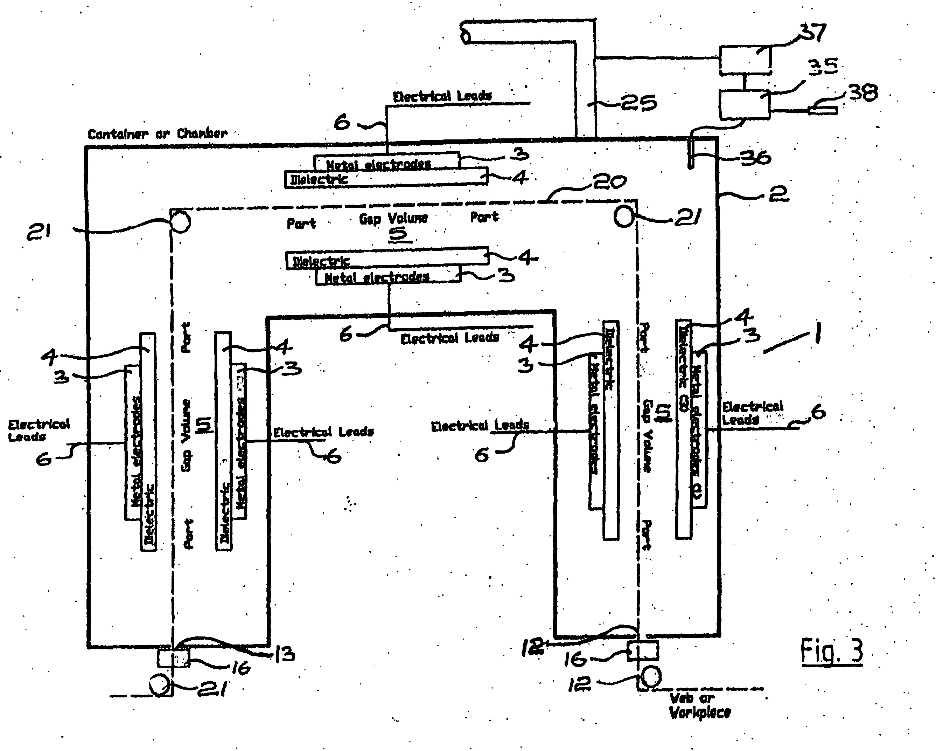

Referring to Fig. 3, there is illustrated a further APP system, again identified generally by the reference numeral 1 and parts similar to those described with reference to the previous drawings, are identified by the same reference numerals. In this embodiment, there is provided a gas pressure sensor 35 having probes 36 and 38. The gas pressure sensor 35 is connected to a controller 37 which is in turn connected to the precursor gas supply. The probe 36 is inside the endosure housing 2 and the probe 38 is mounted outside the enclosure housing 2 to sense ambient pressure.

In operation, the gas pressure sensor 35 records both the pressure inside the enclosure housing 2 and the pressure outside the enclosure housing 2 and delivers both signals to the controller 37, which controller 37 then operates the precursor gas supply to maintain the pressure within the enclosure housing 2 at a preset amount above the ambient pressure. While maintaining the precursor process gas at an elevated pressure will ensure the loss of a certain amount of gas, this gas, however, can be collected at the entry port assembly 10 and the exit port assembly 11 as will be described later. Since the pressure difference is very small, it has been found that, in practice, less than 10 litres per minute from a large system is lost and, as mentioned above, the gas can be collected for recycling. In this particular embodiment, there is shown a mixture of both vertical and horizontal electrode arrays, that is to say, with plasma regions through which the work-piece travels in horizontal direction or in the vertical direction. Such a configuration can produce in each plasma region 5, an atmospheric pressure plasma of the dielectric barrier or silent discharge type or the Corona discharge type, or the atmospheric pressure Glow Discharge type, or any other type of plasma system, depending upon various well known parameters such as gap distance, drive frequency and electrode geometry.

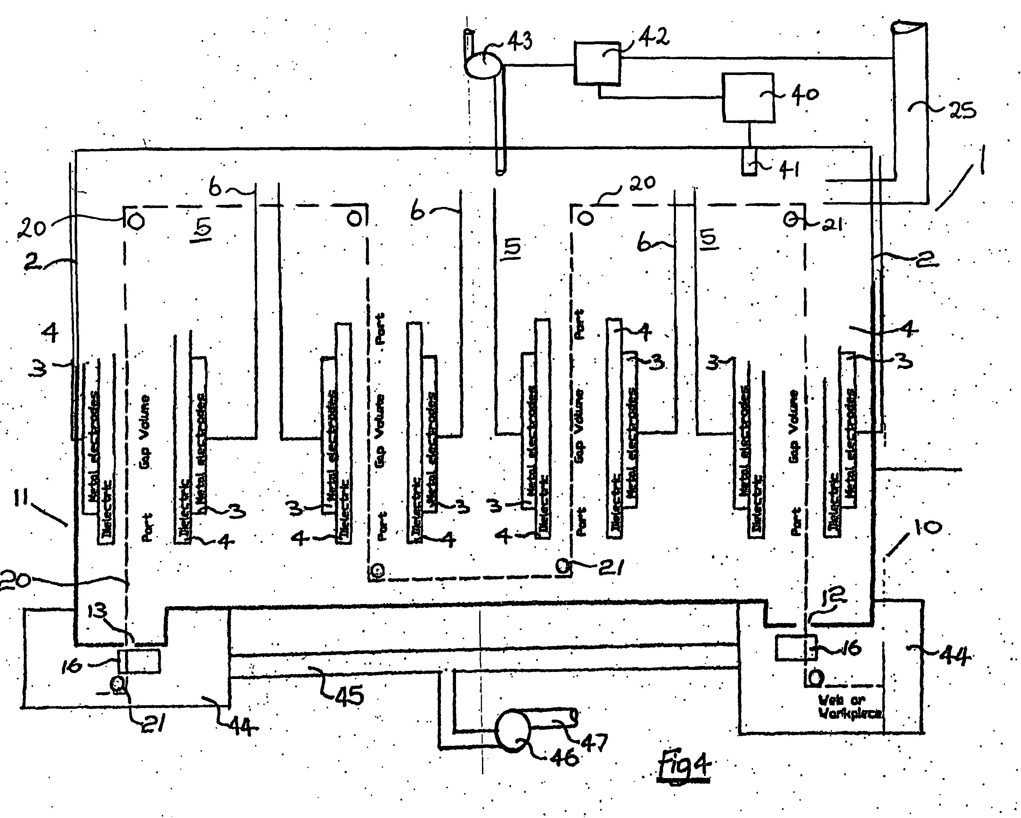

Referring now to Fig. 4, there is illustrated another construction of APP system, again indicated generally by the reference numeral 1. This embodiment illustrates a series of identical vertically arranged electrodes 3 defining effectively vertical plasma regions 5 and it will be noted that a conveyor 20 now moves up and down between the electrode 3 or, depending on how it is considered, back or forth between the electrodes. The one thing that should be noted from this embodiment is that the gas feed pipe 25 is now mounted lower down the enclosure housing 2. in this embodiment, there is mounted a gas analyser 40 having a probe 41 in the upper portion of the enclosure housing 2 remote from the two port assemblies 10 and 11. Connected to the gas analyser 40 is a controller 42 which is in turn connected to an extract fan 43.

A cowling 44 is mounted around each port assembly 10 and 11 and is connected by a conduit 45 to an extract fan 46 which is in turn connected to an extract pipe 47. Gases which are adjacent two port assemblies 10 and 11 will be removed through the cowling 44 by the extract fan 46 for, if necessary, recycling. This embodiment would be particularly useful when the APP system is operated at a pressure greater than atmospheric pressure. In many instances, the fan 46 is not required.

The gas analyser 40 is used to sense the presence of exhaust gases which, in this embodiment, rise to the top of the enclosure housing 2 and are thus lighter than the precursor process gas. These are then removed by the extract fan 46 either to be discharged into the atmosphere or for collection. It will be appreciated that the extract pipe 47 can be connected to a gas collector which, when there is a slight positive pressure in the enclosure 2, is likely to be almost pure precursor process gas. Exhaust gases heavier than the precursor process gas is delivered out the port assemblies 10 and 11.

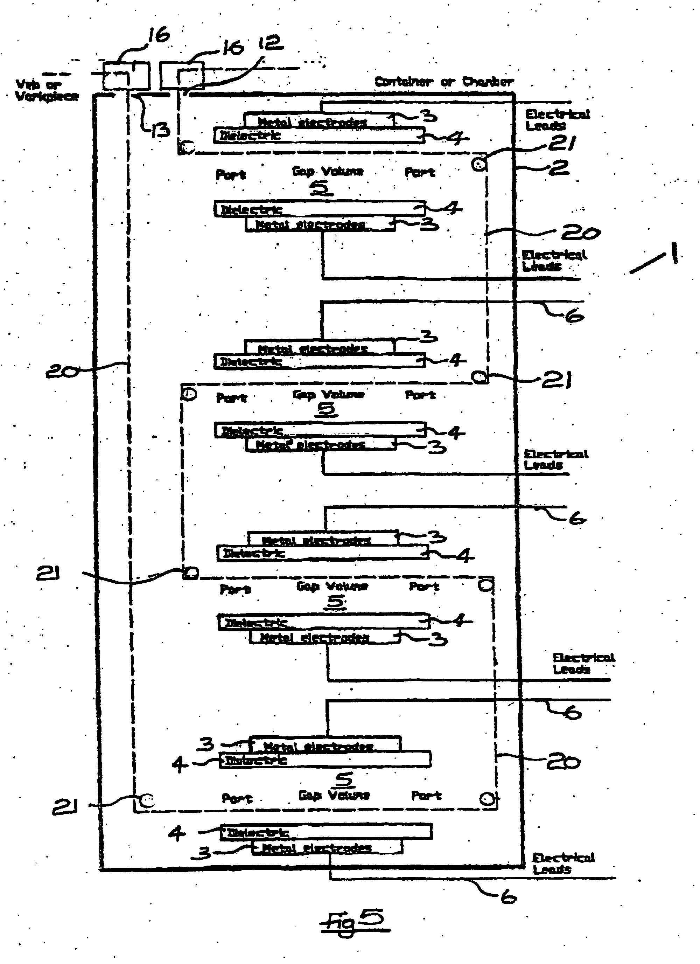

Referring now to Fig. 5, there is illustrated a still further construction of APP system, again indicated generally by the reference numeral 1 and parts similar to those described with reference to previous embodiments are identified by the same reference numerals. In this embodiment, it will be noted that the entry port assembly 10 and the exit port assembly are not formed from an enclosed elongate housing but that the work-piece opening and the work-piece enclosure opening are coincident. It will be noted that in this embodiment, the plasma regions 5 are effectively horizontal and the work-piece passes back and forth between electrodes. This embodiment will only be used for precursor process gases whose relative density is greater than that of ambient air.

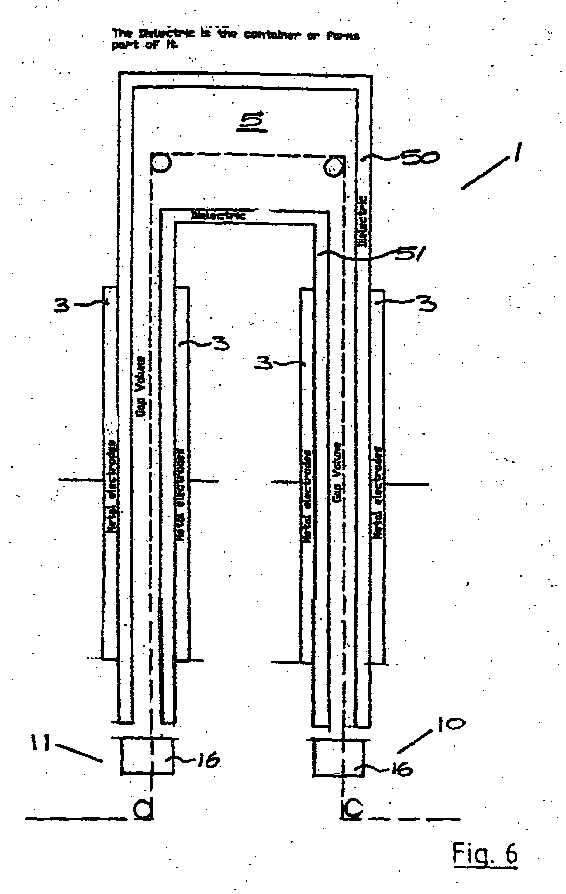

Referring now to Fig. 6, there is illustrated a still further construction of APP system, again identified by the numeral 1. The electrodes 3 are mounted on a pair of U-shaped dielectric members of dielectric material, namely, an outer U-shaped dielectric member 50 and an inner U-shaped member 51. It will be noted that the inner U-shaped member 51 nests within the outer U-shaped member 50 to form the plasma region, again identified by the reference numeral 5 therebetween. The outer U-shaped member carries electrodes 3 and the inner surface of the inner U-shaped member 51 carries the other electrode 3. It will be appreciated that the outer electrode member 50 is an enclosed member, in other words, the ends of the U-shape are closed off to form the outer portion of an enclosure housing, as in this embodiment.

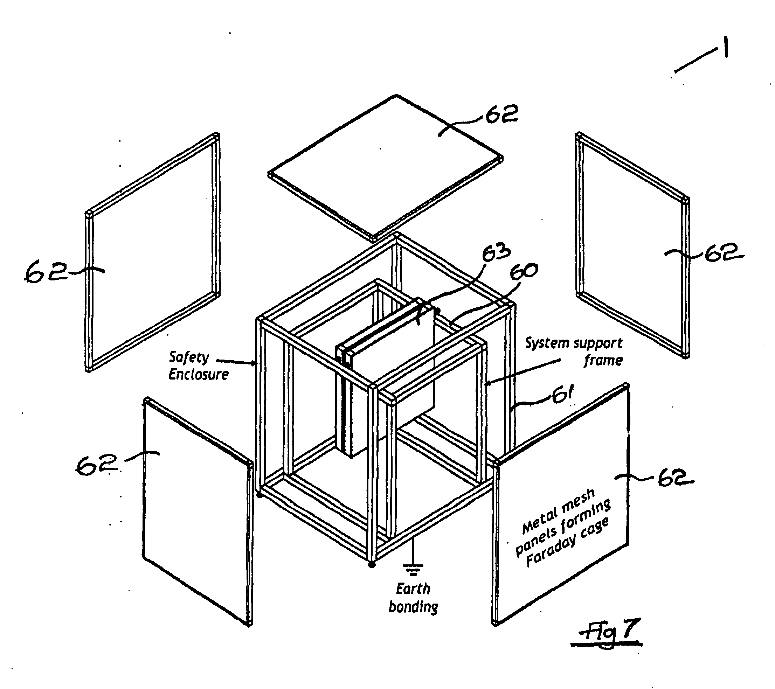

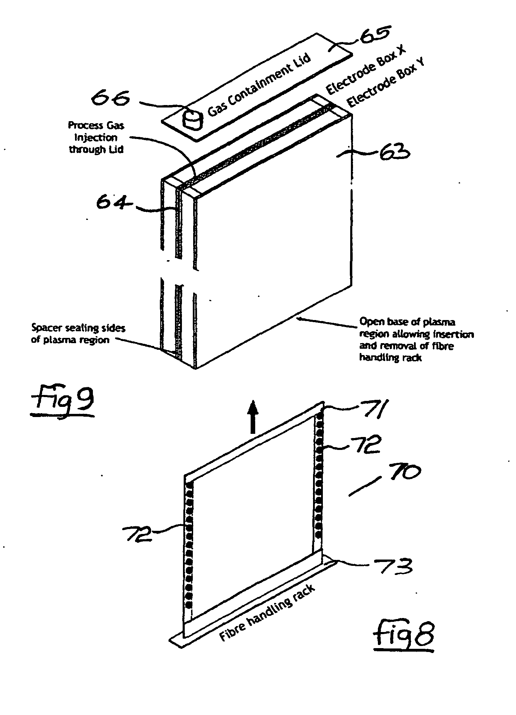

Referring now to Figs. 7 to 12 inclusive, there is illustrated portion of an APP system used for the handling of continuous fibre or yarn, hereinafter "yarn", in a system. The system comprises a multipass fibre handling system. In Fig. 7, there is illustrated this construction of APP system, again indicated generally by the reference numeral 1. In this APP system, there is provided an enclosure housing formed from electrode boxes 63 mounted on a system support frame 60 housed within a further frame 61 covered by metal mesh panels 62 forming a Faraday cage. The metal mesh panels 62 are grounded to complete the Faraday cage.

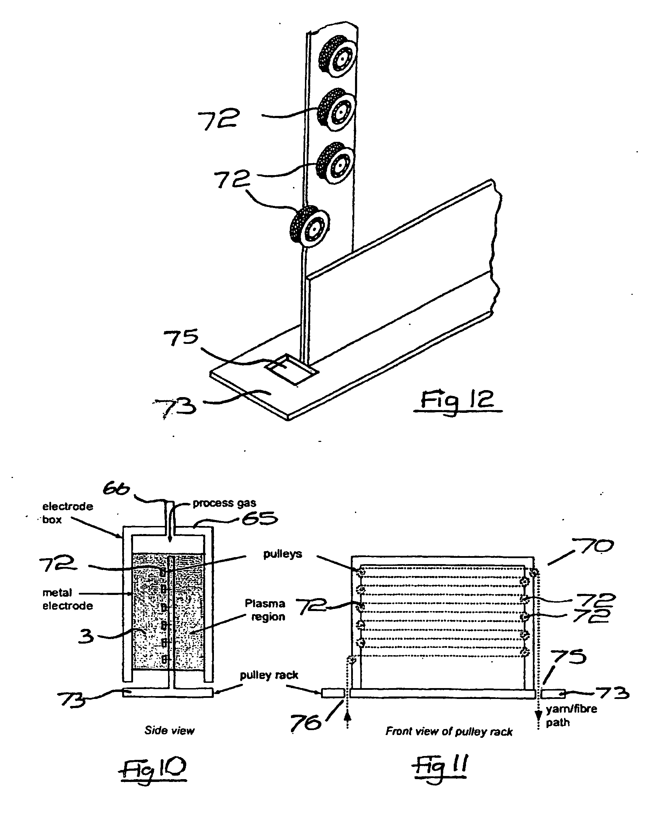

Referring now to Fig. 9, there is illustrated a pair of electrode containing boxes 63 forming part of the enclosure housing. A sealing strip 64 seals the sides of both electrode boxes together and a gas containment lid 65 completes another wall of the enclosure housing. The gas containment lid 65 includes a gas injet pipe 66. A yarn support rack, indicated generally by the reference numeral 70, comprising an open frame 71 mounting opposed pulleys 72 is provided. The yarn support rack 70 includes a base 73 forming effectively the enclosure housing base and has a hole forming a yarn entry port assembly 75 and a hole forming a yarn exit port 76. The outer portion of the each electrode box 63 is of dielectric material and will house an electrode, again identified by the reference numeral 3, as can be seen in Fig. 10.

It will be appreciated that yarn can be fed back and forth across the pulleys providing increased path length and resident time within the plasma region.

It will be appreciated that the present invention has certain advantages over the prior art in that the high cost invoived in using large quantities of expensive gases is largely eliminated. Further, health and safety may be improved, together with a reduction in atmospheric pollution. The present invention provides a more efficient system in that problems of repeatability due to contamination from other gases in the plasma region. are greatly reduced. Anything that can be done to reduce the dragging of gas in or out of the enclosure housing 2 will be advantageous. Thus, as mentioned already, lip seals, brush seals, opposing rollers, security curtains and the like may be used.

It will be appreciated that the electrode geometry is not limited to opposing parallel plate geometry but may comprise practically any geometry, including 3-dimensional non-planar electrodes, for example, point, namely needle array electrodes, wire electrodes, cylindrical electrodes, and so on. It is envisaged that such a configuration used for helium gas provides a surface activation process which can be applied to many materials including, plastics, polymers, inorganics and metal.

In one embodiment, helium as a precursor process gas, can be provided with a radio frequency supply of between 50 to 80 kHz, powered by a suitable RF transformer generating about 2 to 6 kV and using about 1 kW of power. This successfully activates polyolefin textile web, as measured by wettabilty and adhesion after bonding. It was found that when this was run in accordance with the present invention, less than 5% of the quantity of helium gas required in the absence of the gas containment according to the present invention was required. Similarly, argon gas can be used in substantially much the same power and radio frequency ratio.

Various other systems according to the present invention have been used in which precursor process gas contained a mixture comprising argon, together with a fluorine containing halocarbon gas such as C₂F₆, CF₄ or CHF₃. It has been used to deposit a conformal fluorocarbon coating onto any web or work-piece passing through the plasma. Similarly, a gas mixture comprising argon and siloxane vapour deposits a conformal coating of SiOₓ onto any web or work-piece passing through the plasma. A system powered with about 5 to 100 Hz AC current and used with argon gas mobilises fine powder placed in the plasma region and impregnates porous material situated in the same region with such powder.

It is envisaged that the present invention is particularly directed to plasma activation and coating and thin film deposition and also to any surface contamination deaning and etching.

In the specification the terms "comprise, comprises, comprised and comprising" or any variation thereof and the terms "include, includes, included and including" or any variation thereof are considered to be totally interchangeable and they should all be afforded the widest possible interpretation.

The invention is not limited to the embodiments hereinbefore described but may be varied in both construction and detail within the scope of the claims.

## Claims

1. An atmospheric process plasma (APP) system (1) of the non-thermal equilibrium type comprising: electrodes (3) forming a plasma region mounted in a gas-tight enclosure housing (2) having an open to the atmosphere entry port assembly (10) and exit port assembly (11), a non-ambient air precursor process gas having a relative density greater or less than ambient air at the same pressure and temperature and means (20) for moving work-pieces between the electrodes (3) from the entrance port assembly (10) to the exit port assembly (11) **characterised in that** each assembly port (10, 11) comprises an elongate enclosed housing having a work-piece port opening (12, 13) connecting the housing to the outside of the enclosure housing (2) and a vertically spaced-apart work-piece enclosure opening (14, 15) connecting the housing to the enclosure housing (2) and wherein the work-piece enclosure opening (14, 15) is below the work-piece port opening (12, 13) and is sited in the enclosure housing (2) above the plasma region (5) for precursor process gas with a relative density greater than that of the ambient air and below the plasma region (5) and above the work-piece enclosure opening (14, 15) for a gas with a relative density less than that of ambient air.

2. An atmospheric process plasma (APP) system (1) as claimed in claim 1 in which a gas analyser (30) is mounted in the entry port assembly (10).

3. An atmospheric process plasma (APP) system (1) as claimed in claim 1 or 2 in which a gas analyser (30) is located adjacent the work-plece enclosure opening (14, 15).

4. An atmospheric process plasma (APP) system (1) as claimed in any preceding claim in which a gas analyser (30) is mounted in the exit port (11).

5. An atmospheric process plasma (APP) system (1) as claimed in any preceding claim in a gas analyser (30) is mounted adjacent the work-piece port opening (12, 13).

6. An atmospheric process plasma (APP) system (1) as claimed in any of claims 2 to 5 in which the gas analyser (30) is connected to a control means (37) for the introduction of precursor process gas on the quantity of precursor process gas sensed by the analyser (30) falling below a predetermined level.

7. An atmospheric process plasma (APP) system (1) as claimed in any preceding claim in which the precursor process gas is maintained at a positive pressure above ambient pressure outside the enclosure housing (2).

8. An atmospheric process plasma (APP) system (1) as claimed in claim 7 in which the positive pressure of the precursor process gas is less than 10% of ambient.

9. An atmospheric process plasma (APP) system (1) as claimed in claim 8 in which the positive pressure of the precursor process gas is of the order of 1 % of ambient

10. An atmospheric process plasma (APP) system (1) as claimed in any of claims 7 to 9 in which control means (37) are provided whereby the positive pressure is maintained by the introduction of precursor process gas when the pressure within the enclosure housing (2) falls below a predetermined minimum level.

11. An atmospheric process plasma (APP) system (1). as claimed in any preceding claim in which means (25) are provided for continuously introducing precursor process gas into the enclosure housing (2).

12. An atmospheric process plasma (APP) system (1) as claimed in any preceding claim in which means (43) are provided for the collection and removal of gases adjacent the exterior of each port assembly (10, 11) where a work-piece enters or leaves the port assembly (10, 11).

13. An atmospheric process plasma (APP) system (1) as claimed in claim 12 in which the means for collection and removal of the gases comprise a cowling (44) surrounding the port assemblies and an extraction fan (46) associated therewith.

14. An atmospheric process plasma (APP) system (1) as claimed in claim 13 in which the cowling (44) comprises an open gas receiving mouth adjacent the work-piece port opening (12).

15. An atmospheric process plasma (APP) system (1) as claimed in any preceding claim in which an exhaust gas vent is provided in the enclosure on the side of the enclosure opposite to the port assemblies (10, 11) for the collection of exhaust gases having a relative density to that of the process precursor gases whereby they are trapped in the enclosure housing (2).

16. An atmospheric process plasma (APP) system (1)as claimed in claim 15 in which an exhaust gas sensor (40) is mounted in the enclosure housing (2) adjacent the exhaust gas vent

17. An atmospheric process plasma (APP) system (1) as claimed in claim 16 in which control means (42) are connected to the exhaust gas sensor (40) and the exhaust gas vent for the operation of the exhaust gas vent on the level of exhaust gases in the enclosure housing (2) exceeding a predetermined level.

18. An atmospheric process plasma (APP) system (1) as claimed in any preceding claim in which gas flow dampers (16) are mounted in each port assembly.

19. An atmospheric process plasma (APP) system (1) as claimed in claim 18 in which the gas flow dampers comprise one or more of:
lip seals;
brush seals;
curtain seals; and
opposed rollers.

20. An atmospheric process plasma (APP) system (1) as claimed in any preceding claim in which the electrodes (3) are substantially planar electrodes.

21. An atmospheric process plasma (APP) system (1) as claimed in claim 20 in which there are a plurality of electrodes (3) arranged back to back and in which the means for moving the work-pieces between the electrodes comprises a conveyor (20) moving back and forth sequentially between the electrodes (3).

22. An atmospheric process plasma (APP) system (1) as claimed in claim 20 in which the work-piece is endless yarn and the means for moving the work-piece comprises an open frame member (71) for mounting between two electrodes (3), the frame member carrying a plurality of yarn support pulleys (72) on opposite sides of the frame member (71) and a yarn draw-off mechanism.

23. An atmospheric process plasma (APP) system (1) as claimed in any of claims 20 to 22 in which the electrodes (3) comprise a pair of U-shaped members (50, 51) of dielectric material nesting one inside the other to define the plasma region (5) therebetween carrying an electrode (3) on the outer surface of the outer of the two members (50) and carrying a corresponding electrode on the inner surface of the other member (51).

## Patentansprüche

1. Atmosphärisches Prozessplasmasystem (APP-System) (1) vom Typ des nichtthermischen Gleichgewichts, das Folgendes umfasst: Elektroden (3), die einen Plasmabereich bilden und in einem gasdichten Einfassungsgehäuse (2) angeordnet sind, das eine Eingangsöffnungsbaugruppe (10) und eine Ausgangsöffnungsbaugruppe (11) aufweist, die zur Atmosphäre offen sind, ein nicht aus der Umgebungsluft stammendes Vorläuferprozessgas, das eine relative Dichte aufweist, die größer oder kleiner als die Umgebungsluft bei gleichem Druck und gleicher Temperatur ist, sowie Mittel (20) zum Bewegen von Werkstücken zwischen den Elektroden (3) von der Eingangsöffnungsbaugruppe (10) zur Ausgangsöffnungsbaugruppe (11), **dadurch gekennzeichnet, dass** jede Baugruppenöffnung (10, 11) ein längliches eingefasstes Gehäuse umfasst, das ein Werkstücköffnungsloch (12, 13), das das Gehäuse mit der Außenseite des Einfassungsgehäuses (2) verbindet, und ein vertikal beabstandetes Werkstückeinfassungsloch (14, 15) aufweist, das das Gehäuse mit dem Einfassungsgehäuse (2) verbindet, wobei sich das Werkstückeinfassungsloch (14, 15) unterhalb des Werkstücköffnungslochs (12, 13) befindet und in dem Einfassungsgehäuse (2) oberhalb des Plasmabereichs (5) für Vorläuferprozessgas mit einer relativen Dichte angeordnet ist, die größer als die von Umgebungsluft ist, und unterhalb des Plasmabereichs (5) sowie oberhalb der Werkstückeinfassungsöffnung (14, 15) für ein Gas mit einer relativen Dichte, die kleiner als die von Umgebungsluft ist, angeordnet ist.

2. Atmosphärisches Prozessplasmasystem (APP-System) (1) nach Anspruch 1, wobei ein Gasanalysator (30) in der Eingangsöffnungsbaugruppe (10) angeordnet ist.

3. Atmosphärisches Prozessplasmasystem (APP-System) (1) nach Anspruch 1 oder 2, wobei ein Gasanalysator (30) benachbart zum Werkstückeinfassungsloch (14, 15) angeordnet ist.

4. Atmosphärisches Prozessplasmasystem (APP-System) (1) nach einem der vorhergehenden Ansprüche, wobei ein Gasanalysator (30) in der Ausgangsöffnung (11) angeordnet ist

5. Atmosphärisches Prozessplasmasystem (APP-System) (1) nach einem der vorhergehenden Ansprüche, wobei ein Gasanalysator (30) benachbart zum Werkstticköffnungsloch (12, 13) angeordnet ist.

6. Atmosphärisches Prozessplasmasystem (APP-System) (1) nach einem der Ansprüche 2 bis 5, wobei der Gasanalysator (30) mit einem Steuermittel (37) verbunden ist, um Vorläuferprozessgas einzuleiten, wenn die Menge an Vorläuferprozessgas, die vom Analysator (30) gemessen wird, unter einen vorherbestimmten Pegel abfällt.

7. Atmosphärisches Prozessplasmasystem (APP-System) (1) nach einem der vorhergehenden Ansprüche, wobei das Vorläuferprozessgas auf einem positiven Druck oberhalb des Umgebungsdrucks außerhalb des Einfassungsgehäuses (2) gehalten wird.

8. Atmosphärisches Prozessplasmasystem (APP-System) (1) nach Anspruch 7, wobei der positive Druck des Vorläuferprozessgases weniger als 10% des Umgebungsdrucks beträgt.

9. Atmosphärisches Prozessplasmasystem (APP-System) (1) nach Anspruch 8, wobei der positive Druck des Vorläuferprozessgases in der Größenordnung von 1% im Verhältnis zum Umgebungsdruck liegt.

10. Atmosphärisches Prozessplasmasystem (APP-System) (1) nach einem der Ansprüche 7 bis 9, wobei Steuermittel (37) bereitgestellt sind, mit denen durch Einleiten von Vorläuferprozessgas der positive Druck aufrechterhalten wird, wenn der Druck innerhalb des Einfassungsgehäuses (2) unter einen vorherbestimmten Mindestpegel abfällt.

11. Atmosphärisches Prozessplasmasystem (APP-System) (1) nach einem der vorhergehenden Ansprüche, wobei Mittel (25) bereitgestellt sind, die fortwährend Vorläuferprozessgas in das Einfassungsgehäuse (2) einleiten.

12. Atmosphärisches Prozessplasmasystem (APP-System) (1) nach einem der vorhergehenden Ansprüche, wobei Mittel (43) bereitgestellt sind, die Gase benachbart zur Außenseite jeder Öffnungsbaugruppe (10, 11) dort sammeln und entfernen, wo ein Werkstück in die Öffnungsbaugruppe (10, 11) eintritt oder diese verlässt.

13. Atmosphärisches Prozessplasmasystem (APP-System) (1) nach Anspruch 12, wobei die Mittel zum Sammeln und Entfernen der Gase eine Verkleidung (44), die die Öffnungsbaugruppen umgibt, sowie ein dazugehöriges Abzugsgebläse (46) umfassen.

14. Atmosphärisches Prozessplasmasystem (APP-System) (1) nach Anspruch 13, wobei die Verkleidung (44) benachbart zum Werkstücköffnungsloch (12) eine offene Gasaufnahmeöffnung umfasst.

15. Atmosphärisches Prozessplasmasystem (APP-System) (1) nach einem der vorhergehenden Ansprüche, wobei eine Abgasentlüftung in der Einfassung an der Seite der Einfassung gegenüber den Öffnungsbaugruppen (10, 11) zum Sammeln von Abgasen vorgesehen ist, die im Verhältnis zu den Prozessvorläufergasen eine relative Dichte aufweisen, wobei sie im Einfassungsgehäuse (2) eingefangen werden.

16. Atmosphärisches Prozessplasmasystem (APP-System) (1) nach Anspruch 15, wobei ein Abgassensor (40) in dem Einfassungsgehäuse (2) benachbart zur Abgasentlüftung angeordnet ist.

17. Atmosphärisches Prozessplasmasystem (APP-System) (1) nach Anspruch 16, wobei Steuermittel (42) mit dem Abgassensor (40) und der Abgasentlüftung verbunden sind, um die Abgasentlüftung zu betreiben, wenn der Abgaspegel im Einfassungsgehäuse (2) einen vorherbestimmten Pegel überschreitet.

18. Atmosphärisches Prozessplasmasystem (APP-System) (1) nach einem der vorhergehenden Ansprüche, wobei in jeder Öffnungsbaugruppe Gasströmungsdämpfer (16) angeordnet sind.

19. Atmosphärisches Prozessplasmasystem (APP-System) (1) nach Anspruch 18, wobei die Gasströmungsdämpfer eins oder mehrere der folgenden Elemente aufweisen:
Lippendichtungen;
Bürstendichtungen;
Schürzendichtungen; und
gegenüberliegende Walzen.

20. Atmosphärisches Prozessplasmasystem (APP-System) (1) nach einem der vorhergehenden Ansprüche, wobei die Elektroden (3) im Wesentlichen Planarelektroden sind.

21. Atmosphärisches Prozessplasmasystem (APP-System) (1) nach Anspruch 20, wobei eine Vielzahl von Elektroden (3) Rücken an Rücken angeordnet ist und das Mittel zum Bewegen der Werkstücke zwischen den Elektroden eine Fördervorrichtung (20) umfasst, die sich sequenziell zwischen den Elektroden (3) vor- und zurückbewegt.

22. Atmosphärisches Prozessplasmasystem (APP-System) (1) nach Anspruch 20, wobei das Werkstück Endlosgarn ist, das Mittel zum Bewegen des Werkstücks ein offenes Rahmenelement (71) zur Anbringung zwischen zwei Elektroden (3) umfasst und das Rahmenelement eine Vielzahl von Gamstützrollen (72) an gegenüberliegenden Seiten des Rahmenelements (71) sowie einen Garnabwickelmechanismus trägt.

23. Atmosphärisches Prozessplasmasystem (APP-System) (1) nach einem der Ansprüche 20 bis 22, wobei die Elektroden (3) ein Paar U-förmige Elemente (50, 51) aus dielektrischem Material umfassen, von denen eins im anderen angeordnet ist, um den Plasmabereich (5) dazwischen zu bilden, die eine Elektrode (3) an der äußeren Oberfläche des äußeren der beiden Elemente (50) und eine entsprechende Elektrode an der inneren Oberfläche des anderen Elements (51) tragen.

## Revendications

1. Un système (1) de plasma à procédé atmosphérique (APP) de type à équilibre non thermique comprenant : des électrodes (3) formant une région de plasma montées dans une enceinte étanche aux gaz (2) ayant un ensemble orifice d'entrée (10) et un ensemble orifice de sortie (11) ouverts à l'atmosphère, un gaz de procédé précurseur qui n'est pas l'air ambiant ayant une densité relative supérieure ou inférieure à celle de l'air ambiant à la même pression et température et un moyen (20) pour déplacer les pièces à travailler entre les électrodes (3) de l'ensemble orifice d'entrée (10) à l'ensemble orifice de sortie (11) **caractérisé en ce que** chaque ensemble orifice (10, 11) comprend un boîtier fermé allongé ayant une ouverture de l'orifice de pièce à travailler (12, 13) raccordant le boîtier à l'extérieur de l'enceinte (2) et une ouverture de l'enceinte de pièce à travailler (14, 15), distancée verticalement, raccordant le boîtier à l'enceinte (2) et où l'ouverture de l'enceinte de pièce à travailler (14,15) est au-dessous de l'ouverture de l'orifice de la pièce à travailler (12, 13) et est située dans l'enceinte (2) au-dessus de la région du plasma (5) pour le gaz de procédé précurseur d'une densité relative supérieure à celle de l'air ambiant et au-dessous de la région de plasma (5) et au-dessus de l'ouverture de l'enceinte de la pièce à travailler (14, 15) pour un gaz d'une densité relative inférieure à celle de l'air ambiant.

2. Un système (1) de plasma à procédé atmosphérique (APP) selon la revendication 1 dans lequel un analyseur de gaz (30) est monté dans l'ensemble orifice d'entrée (10).

3. Un système (1) de plasma à procédé atmosphérique (APP) selon la revendication 1 ou 2 dans lequel un analyseur de gaz (30) est situé à côté de l'ouverture de l'enceinte de la pièce à travailler (14, 15).

4. Un système (1) de plasma à procédé atmosphérique (APP) selon l'une quelconque des revendications précédentes dans lequel un analyseur de gaz (30) est monté sur l'orifice de sortie (11).

5. Un système (1) de plasma à procédé atmosphérique (APP) selon l'une quelconque des revendications précédentes dans lequel un analyseur de gaz (30) est monté à côté de l'ouverture de l'orifice de la pièce à travailler (12, 13).

6. Un système (1) de plasma à procédé atmosphérique (APP) selon l'une quelconque des revendications 2 à 5 dans lequel l'analyseur de gaz (30) est raccordé à un moyen de contrôle (37) pour l'introduction du gaz de procédé précurseur lorsque la quantité de gaz de procédé précurseur détectée par l'analyseur (30) descend au-dessous d'une valeur prédéterminée.

7. Un système (1) de plasma à procédé atmosphérique (APP) selon l'une quelconque des revendications précédentes dans lequel le gaz de procédé précurseur est maintenu à une pression positive supérieure à la pression ambiante à l'extérieur de l'enceinte (2).

8. Un système (1) de plasma à procédé atmosphérique (APP) selon la revendication 7 dans lequel la pression positive du gaz de procédé précurseur est moins de 10% de la pression ambiante.

9. Un système (1) de plasma à procédé atmosphérique (APP) selon la revendication 8 dans lequel la pression positive du gaz de procédé précurseur est de l'ordre de 1% de la pression ambiante.

10. Un système (1) de plasma à procédé atmosphérique (APP) selon l'une quelconque des revendications 7 à 9 dans lequel des moyens de contrôle (37) sont fournis par lesquels la pression positive est maintenue par l'introduction du gaz de procédé précurseur lorsque la pression dans l'enceinte (2) descend au-dessous d'une valeur minimum prédéterminée.

11. Un système (1) de plasma à procédé atmosphérique (APP) selon l'une quelconque des revendications précédentes dans lequel des moyens (25) sont fournis pour introduire continuellement le gaz de procédé précurseur dans l'enceinte (2).

12. Un système (1) de plasma à procédé atmosphérique (APP) selon l'une quelconque des revendications précédentes dans lequel des moyens (43) sont fournis pour la collecte et l'extraction des gaz adjacents à l'extérieur de chaque ensemble orifice (10, 11) où une pièce à travailler entre ou quitte l'ensemble orifice (10, 11).

13. Un système (1) de plasma à procédé atmosphérique (APP) selon la revendication 12 dans lequel les moyens de collecte et d'extraction des gaz comprennent un capot (44) entourant les ensembles orifices et un ventilateur d'extraction (46) associés avec celiu-ci.

14. Un système (1) de plasma à procédé atmosphérique (APP) selon la revendication 13 dans lequel le capot (44) comprend une embouchure réceptrice de gaz ouverte à côté de l'ouverture de l'orifice de la pièce à travailler (12).

15. Un système (1) de plasma à procédé atmosphérique (APP) selon l'une quelconque des revendications précédentes dans lequel un évent des gaz d'échappement est fourni dans l'enceinte sur le côté de l'enceinte à l'opposé des ensembles orifices (10, 11) pour la collecte des gaz d'échappement ayant une densité relative à celle des gaz précurseurs du procédé étant ainsi piégés dans l'enceinte (2).

16. Un système (1) de plasma à procédé atmosphérique (APP) selon la revendication 15 dans lequel un détecteur de gaz d'échappement (40) est monté dans l'enceinte (2) à côté de l'évent des gaz d'échappement.

17. Un système (1) de plasma à procédé atmosphérique (APP) selon la revendication 16 dans lequel des moyens de contrôle (42) sont raccordés au détecteur des gaz d'échappement (40) et à l'évent des gaz d'échappement pour actionner l'évent des gaz d'échappement lorsque le niveau des gaz d'échappement dans l'enceinte (2) dépasse une valeur prédéterminée.

18. Un système (1) de plasma à procédé atmosphérique (APP) selon l'une quelconque des revendications précédentes dans lequel des registres d'écoulement des gaz (16) sont montés dans chaque ensemble orifice.

19. Un système (1) de plasma à procédé atmosphérique (APP) selon la revendication 18 dans lequel les registres d'écoulement des gaz (16) comprennent un ou plusieurs :
joints à lèvre ;
joints à balai;
joints souples ; et
rouleaux opposés.

20. Un système (1) de plasma à procédé atmosphérique (APP) selon l'une quelconque des revendications précédentes dans lequel les électrodes (3) sont essentiellement des électrodes planes.

21. Un système (1) de plasma à procédé atmosphérique (APP) selon la revendication 20 dans lequel il y a plusieurs électrodes (3) disposées dos à dos et dans lequel le moyen de déplacement des pièces à travailler entre les électrodes comprend un convoyeur (20) se déplaçant séquentiellement en avant et en arrière entre les électrodes (3).

22. Un système (1) de plasma à procédé atmosphérique (APP) selon la revendication 20 dans lequel la pièce à travailler est un fil sans fin et le moyen de déplacer la pièce à travailler comprend un élément de cadre ouvert (71) à monter entre deux électrodes (3), l'élément de cadre portant plusieurs poulies de support de fil (72) sur les côtés opposés de l'élément de cadre (71) et un mécanisme de tirage de fil.

23. Un système (1) de plasma à procédé atmosphérique (APP) selon l'une quelconque des revendications 20 à 22 dans lequel les électrodes (3) comprennent une paire d'éléments en forme de U (50, 51) de matériau diélectrique emboîtés l'un dans l'autre pour définir la région du plasma (5) entre eux portant une électrode (3) sur la surface extérieure de l'élément extérieur des deux éléments (50) et portant une électrode correspondante sur la surface intérieure de l'autre élément (51).
